Europäisches Patentamt

European Patent Office

Office européen des brevets

(11) Publication number: **0 322 157**
**A1**

## EUROPEAN PATENT APPLICATION

(21) Application number: 88311893.7

(51) Int. Cl.⁴: **H03H 11/12**

(22) Date of filing: **15.12.88**

(30) Priority: **18.12.87 US 135117**

(43) Date of publication of application:
**28.06.89 Bulletin 89/26**

(84) Designated Contracting States:
**FR GB**

(71) Applicant: **ROCKWELL INTERNATIONAL CORPORATION**
**1200 N. Alma Road**
**Richardson Texas 75081(US)**

(72) Inventor: **Young, James P.**
**2022 Bever Avenue SE**
**Cedar Rapids Iowa 52403(US)**

(74) Representative: **Jackson, David Spence et al**
**REDDIE & GROSE 16, Theobalds Road**
**London, WC1X 8PL(GB)**

(54) **Active low-pass filter for use with high frequency signal source apparatus.**

(57) A single FET (76) in a common drain mode is substituted for an operational amplifier in a active low-pass filter circuit (68, 72, 74, 82, 76, 84, 80). The detrimental effects of having a gain less than one, and only moderately low output impedance are more than couterbalanced by a substantially constant gain obtained over a range of frequencies exceeding that presently available for conventional prior art operational amplifier active filter approaches. The filter circuit is particularly intended for use as as a low-pass filter eliminating local oscillator frequency at 1.4 GHz from the output of a mixer (56, 58, 50, 60, 64).

FIG. 3

EP 0 322 157 A1

## Active Low-Pass Filter for use with High Frequency Signal Source Apparatus

The present invention is concerned generally with electronic mixing circuits and more specifically with an inexpensive low-pass filter with a small number of components for filtering signals in the GHz range.

Mixer circuits for mixing RF and local oscillator signals provide an output of intermediate frequency signal and local oscillator frequency signal. The local oscillator signal needs to be filtered and removed so that only the intermediate frequency remains. A typical prior art approach on integrated circuits has been to use an operational amplifier as part of an active filter network for cutoff frequencies below 500 MHz and a passive filter for frequencies above 500 MHz. Both circuits require a large area for frequencies below 2GHz. Since the present invention is preferably incorporated in a monolithic gallium arsenide chip, it is desirable to have as few components as possible to increase yield and decrease the cost of an integrated circuit. In addition, the active filter degrades in gain and isolation for frequencies above 500 MHz. In fact, most operational amplifiers are not specified for frequencies above 500 MHz and would, therefore, give unpredictable results above this frequency. If, therefore, the local oscillator frequency is beyond the frequency capability of the operational amplifier, the ability of an active low-pass filter to filter off the local oscillator leaving the desired IF frequency is very poor (far from the ideal response).

According to one aspect of the present invention there is provided active low-pass filter apparatus comprising, in combination: signal input first means for providing an input signal to be filtered; solid state current amplifying second means including signal input means and signal output terminal third and fourth means; resistor fifth means connected to said signal output terminal third means of said second means, the signal output terminal being used providing a voltage gain of less than 1; filtered signal output sixth means connected to said third means for providing a filtered output signal; power supply seventh means connected across the series combination of said fifth means and the signal output terminal fourth means of said second means; resistive eighth means, including an intermediate tap, connected between said first means and said signal input means of said second means; capacitive feedback ninth means connected between said sixth means and said intermediate tap of said eighth means; and capacitive tenth means connected between said signal input means of said second means and a terminal of said seventh means.

According to another aspect of the invention there is provided active low-pass filter apparatus comprising, in combination: signal input first means for providing an input signal to be filtered; FET second means including gate means, source means and drain means; resistor third means connected to said source means of said second means; filtered signal output fourth means connected to said source means of said second means for providing a filtered output signal; power supply fifth means connected from said drain means across the series combination of said FET second and said resistor means; resistive sixth means, including an intermediate tap, connected between said first means and said gate means of said second means; capacitive feedback seventh means connected between said source means and said intermediate tap of said sixth means; and capacitive eighth means connected between said gate means of said second means and the end of said third means connected to said fifth means.

According to further aspect of the invention there is provided monolithic signal mixer and active low-pass filter apparatus on a single solid state chip comprising, in combination: dual gate mixer first means for providing output first signals to be low-pass filtered; FET second means including gate means, source means and drain means; resistor third means connected to said source means of said second means, filtered signal output fourth means connected to said source means of said second means for providing a low-pass filtered output signal; power supply fifth means connected from said drain means across the series combination of said FET second and said resistor third means; resistive sixth means, including an intermediate tap, connected between said first means and said gate means of said second means; capacitive feedback seventh means connected between said source means and said intermediate tap of said sixth means; and capacitive eighth means conenected between said gate means of said second means and the end of said third means connected to said fifth means.

According to yet another aspect of the invention there is provided active low-pass filter apparatus comprising, in combination: signal amplification first means, including input means and output means, said first means having a voltage gain of less than 1 and having a relatively constant input impedance over the primary range of signal frequencies to be both passed and rejected; capacitive feedback second means connected to said output means of said first means for returning output signals to said input means of said first means; and resistive-capacitive input impedance third means connected to said second means and said input means of said first means, said third means acting to maintain a large input load impedance for signal sources supplying both the signals to be passed and to be rejected while providing signals to said input of said first means representative of both the signal to be passed and the output feedback signal.

The mixer supplying the signals to the preferred embodiment of the present invention mixes an RF of 1.575 GHz with a local oscillator frequency of 1.401 GHz, so that the output signal is a combination of 174 MHz IF signals and 1.401 GHz local oscillator signals.

The present invention, by utilizing a single FET and the associated capacitor and resistor components, achieves the requirements of good, high frequency isolation, few components, and a physically small required area for the total chip.

It is thus an object of the present invention to provide an improved active low-pass filter for use in high frequency environments.

The present invention will now be described by way of example with reference to the accompanying drawings, in which:

Figure 1 is a block diagram of a mixing circuit;

Figure 2 is a schematic diagram of a prior art active low-pass filter; and

Figure 3 illustrates a schematic digram of a mixing circuit embodying the present invention.

DETAILED DESCRIPTION

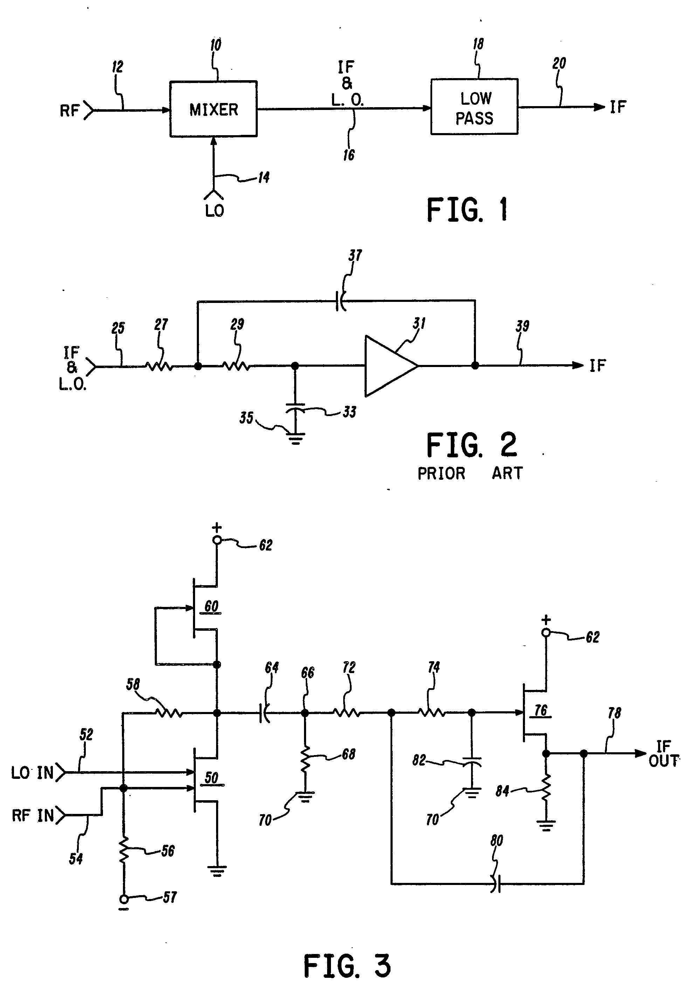

In Figure 1, a mixer 10 receives RF input signals on a lead 12 and local oscillator (L.O.) signals on a lead 14. After mixing, intermediate frequency and local oscillator signals are supplied on a lead 16 to a low-pass filter 18 for removal of the local oscillator signals, so that only IF signals are supplied from the low-pass filter on an input lead 20.

In Figure 2, a prior art design of the low-pass filter of block 18 of Figure 1 is shown, where the active element of the low-pass filter is an operational amplifier. In Figure 2, an input signal is supplied on a lead 25 through a pair of resistors 27 and 29 to an input of an operational amplifier 31. A capacitor 33 is shown connected between the input of amplifier 31 and ground 35. An output of the amplifier 31 is returned through a feedback capacitor 37 to a junction between resistors 27 and 29 and also is used to supply output signals at an output 39.

In the mixing circuit of Figure 3, a dual gate FET generally designated as 50, has L.O. first and R.F. second inputs 52 and 54. A resistor 56 connects the lead 54 to a negative potential power terminal 57. The gate lead 54 is also connected through a resistor 58 to the drain of FET 50, a well as to a source lead of a further FET 60. The gate of FET 60 is connected directly to the source of FET 60. The drain of FET 60 is connected to a positive potential power terminal 62. A capacitor 64 is connected between the drain of FET 50 and a junction point 66. A resistor 68 is connected between junction point 66 and ground 70. A pair of resistors 72 and 74 are connected between junction point 66 and a gate of an FET 76. A drain of FET 76 is connected to a positive potential power terminal which may be the same as previously designated 62. The source of FET 76 is connected to an output lead 78. A capacitor 80 is connected between output lead 78 and a junction between previously designated resistors 72 and 74. A capacitor 82 is connected between the gate of FET 76 and ground 70. A resistor 84 is connected between output lead 78 and ground 70.

OPERATION

Figure 2 illustrates a prior art example of an active low-pass filter. Information may be found in many publications on active filters and one of these is Passive and Active Network Analysis and Synthesis by Aram Budak, published by the Houghton Mifflin Publishing Company and copyrighted in 1974. Information on a low-pass filter of the type shown in Figure 2 commences on page 323, and requires for the ideal low-pass filter an operational amplifier, such as amplifier 31, that must also be ideal. The qualifications for an ideal operational amplifier an presented in the same book on page 190. This ideal operational amplifier should have infinite input impedance, infinite gain, and zero output impedance. In the ideal amplifier 31, the value of the gain of the operational amplifier is set to be one by feedback. Since in practice, the operational amplifier is non-ideal, the ideal amplifier can only be approximated. However, the operational amplifier still has an extremely high gain (typically more than 1,000) in the open loop condition, and has high input impedance (much more than a typical line impedance of 50 ohms) and extremely low output impedance (again compared to a typical line impedance).

A problem arising in the case of the prior art circuit of Figure 2 is that the frequency range of the operational amplifier does not extend to a local oscillator frequency of 1.4 GHz., i.e. the circuit of Figure 2 did not present high attenuation of a local oscillator frequency of 1.4 GHz. The operational requirements of many available mixers result in output of a large local oscillator signal which can seriously degrade circuits which follow if not attenuated to an acceptable level.

Since no known operational amplifiers could be found having the requisite frequency range, and since it was undesirable to make an integrated circuit chip physically large enough to incorporate a passive filter using inductances and other reactive impedances, the single FET active filter of Figure 3 was originated.

In operation, the FET 76 of Figure 3 replaces the operational amplifier 31 of Figure 2. The primary differences are, that the FET circuit provides a substantially constant gain over the range of frequencies from 175 MHz to 1.4 GHz, which the operational amplifier could not provide, and the FET amplifier circuit gain is less than 1, since it is operated in a common source configuration and the output impedance is not very low. The gain of the FET from input gate to output lead 78 in one embodiment ranges in the neighbourhood of 0.6 to 0.3. The output impedance is about 50 ohms. Such a concept, of course, completely violates prior art teachings as to the type of active element used in an active filter, since the gain was not only infinite but was actually less than 1. In other words, the FET circuit complies with only one of the three requirements for the amplifier portion of a low-pass filter: it has high input impedance.

In summary, the preferred embodiment of the present invention comprising the circuit starting with the resistor 68 of Figure 3 to the capacitor 80 of Figure 3, comprises an active low-pass filter using a solid state device, such as an FET, operating in a mode which has a voltage gain of less than 1, and which mode promotes a high input impedance and moderately low output impedance. In the case of a collector, emitter transistor, it would be an emitter follower mode an in the case of and FET, it would be a source follower or common source mode.

While it is realized that the absence of the high gain and moderate output impedance for the active element produces a filtering action of lower quality than would be provided if the active element had a high gain and low output impedance, the saving in space for the circuit will more than offset the lower quality of filtering action for some circuit applications. In actual practice, the voltage gain in the passband of the active filter of Figure 2 with an ideal amplifier would be less than -2dB. This would also be true for a passive filter. The filter in Figure 3 in its passband has been measured (in one embodiment) to have a passband voltage gain of -4 to -5dB.

There has thus been illustrated a single embodiment of the inventive concept, wherein an active low-pass filter is designed using an active element having a voltage gain of less than 1.

## Claims

1. Active low-pass filter apparatus comprising, in combination:
signal input first means for providing an input signal to be filtered;
solid state current amplifying second means including signal input means and signal output terminal third and fourth means;
rsistor fifth means connected to said signal output terminal third means of said second means, the signal output terminal being used providing a voltage gain of less than 1;
filtered signal output sixth means connected to said third means for providing a filtered output signal;
power supply seventh means connected across the series combination of said fifth means and the signal output terminal fourth means of said second means;
resistive eighth means, including an intermediate tap, connected between said first means and said signal input means of said second means;
capacitive feedback ninth means connected between said sixth means and said intermediate tap of said eighth means, and
capacitive tenth means connected between said signal input means of said second means and a terminal of said seventh means.

2. Active low-pass filter apparatus comprising, in combination:
signal input first means for providing an input signal to be filtered;
FET second means including gate means, source means and drain means;
resistor third means connected to said source means of said second means;
filtered signal output fourth means connected to said source means of said second means for providing a filtered output signal;
power supply fifth means connected from said drain means across the series combination of said FET second and said resistor third means;
resistive sixth means, including an intermediate tap, connected between said first means and said gate means of said second means;
capacitive feedback seventh means connected between said source means and said intermediate tap of said sixth means; and
capacitive eighth means connected between said gate means of said second means and the end of said third means connected to said fifth means.

3. Monolithic signal mixer and active low-pass filter apparatus on a single solid state chip comprising, in combination:
dual gate mixer first means for providing output first signals to be low-pass filtered;
FET second means including gate means, source means and drain means;
resistor third means connected to said source means of said second means;
filtered signal output fourth means connected to said source means of said second means for providing a low-pass filtered output signal;
power supply fifth means connected from said drain means across the series combination of said FET second and said resistor third means;
resistive sixth means, including an intermediate tap, connected between said first means and said gate means of said second means;
capacitive feedback seventh means connected between said source means and said intermediate tap of said sixth means; and
capacitive eighth means connected between said gate means of said second means and the end of said third means connected to said fifth means.

4. Active low-pass filter apparatus comprising, in combination:
signal amplification first means, including input means and output means, said first means having a voltage gain of less than 1 and having a relatively constant input impedance over the primary range of signal frequencies to be both passed and rejected;
capacitive feedback second means connected to said output means of said first means for returning output signal to said input means of said first means; and
resistive-capacitive input impedance third means connected to said second means and said input means of said first means, said third means acting to maintain a large input load impedance for signal sources supplying both the signals to be passed and to be rejected while providing signals to said input of said first means representative of both the signal to be passed and the output feedback signal.

5. An active low-pass filter comprising a transistor (76) arranged to operate in an emitter follower mode or a source follower mode or a common source mode, and having a resistance-capacitance input coupling (74, 82) and a capacitive feedback coupling (80) from an output terminal (78) to an input terminal of the input coupling (74, 82).

6. An active low-pass filter according to claim 5, characterised in that a further input resistance coupling (68, 72) is connected to the said input terminal.

## FIG. 1

IF & L.O.

MIXER

LOW PASS

RF

LO

IF

## FIG. 2

PRIOR ART

IF & L.O.

IF

## FIG. 3

LO IN

RF IN

IF OUT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-3 501 709 (UETRECHT)<br>* Column 5, line 26 - column 6, line 3; figure 4 * | 1,4-6 | H 03 H 11/12 |
| Y | | 2 | |
| A | | 3 | |
| Y | DICKSON APPLICATION NOTES, vol. 1, no. 8, April 1967, Dickson Electronics Corporation, Scottsdale, US; "Silicon "TOP" epitaxial field-effect transistors"<br>* Figures 1b,7 * | 2 | |
| A | IDEM | 3 | |
| A | IEEE TRANSACTIONS ON MICROWAVE THEORY AND TECHNIQUES, vol. MTT-33, no. 11, November 1985, pages 1231-1235, IEEE, New York, US; K. HONJO et al.: "X-band low-noise GaAs monolithic frequency converter"<br>* Page 1232, paragraph II entitled "Circuit design"; figures 1,2 * | 3 | TECHNICAL FIELDS SEARCHED (Int. Cl.4) |
| A | US-A-3 976 944 (KRENG et al.)<br>* Column 2, line 10 - column 4, line 33; figure 1 *<br>-/- | 3 | H 03 D<br>H 03 H<br>H 03 F |

The present search report has been drawn up for all claims

| Place of search | Date of completion of the search | Examiner |
|---|---|---|
| THE HAGUE | 30-03-1989 | BALBINOT H. |

Application Number

EP  88 31 1893

**·European Patent Office**

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | IEEE TRANSACTIONS ON CONSUMER ELECTRONICS, vol. CE-32, no. 3, August 1986, pages 644-650, IEEE, New York, US; T. FUKUDA et al.: "A fully integrated filter circuit for VCRs" * Page 645, paragraph 3-1 entitled "Eliminating the need for adjustment"; figures 2-4 * ----- | 3 | |
| | | | **TECHNICAL FIELDS SEARCHED (Int. Cl.4)** |

The present search report has been drawn up for all claims

| Place of search | Date of completion of the search | Examiner |
|---|---|---|
| THE HAGUE | 30-03-1989 | BALBINOT H. |

CATEGORY OF CITED DOCUMENTS

X : particularly relevant if taken alone
Y : particularly relevant if combined with another
 document of the same category
A : technological background
O : non-written disclosure
P : intermediate document

T : theory or principle underlying the invention
E : earlier patent document, but published on, or
 after the filing date
D : document cited in the application
L : document cited for other reasons
...................................................................................................
& : member of the same patent family, corresponding
 document

EPO FORM 1503 03.82 (P0401)